# EUROPEAN PATENT SPECIFICATION

(11) **EP 3 598 570 B1**
(45) Date of publication and mention of the grant of the patent: **23.02.2022**
(21) Application number: 19186363.8
(22) Date of filing: 15.07.2019
(51) Int. Cl.: H01Q 9/04, H01Q 1/38, H05K 1/11, H05K 1/16, H01Q 1/22, H01Q 1/52, H01Q 9/42, H01Q 21/28

(54) **PRINTED CIRCUIT BOARD FOR CONTROL UNIT OF AN ALARM SYSTEM**
LEITERPLATTE FÜR STEUEREINHEIT EINES ALARMSYSTEMS
CARTE DE CIRCUIT IMPRIMÉ POUR UNITÉ DE COMMANDE D'UN SYSTÈME D'ALARME

(30) Priority: 16.07.2018 ES 201830714 U
(43) Date of publication of application: 22.01.2020
(73) Proprietor: Verisure Sàrl, 1290 Versoix (CH)
(72) Inventor: Blomé, Olof, 1290 Versoix, Geneva (CH)
(74) Representative: Prinz & Partner mbB

(56) References cited:
- CN-A- 103 682 625
- US-A1- 2002 163 473
- US-A1- 2017 085 000

## Description

The invention relates to a multi-layered printed circuit board (PCB) having at least one cellular antenna on an outermost layer. This PCB is particularly suitable for a control unit for an alarm system as is used in buildings.

The term "building" here refers to small businesses and homes. These can be houses or flats within a house.

The antenna is used for sending communicating with an external operation center. It needs a ground free area around it to optimize efficiency. The provision of a ground free area around the antenna however involves the risk that there is a delamination of the layers of the PCB.

From US 2002/0 163 473 A1 a PCB having a F-shaped antenna is known. To connect ground layers of the PCB, several through holes are arranged in the vicinity of the antenna.

Further, CN 103 682 625 A discloses a multiple-input multiple-output antenna having two monopole antennas arranged in a mirror configuration on a PCB. Between the two monopole antennas, a band gap structure is arranged being connected to a floor panel of the PCB.

The object of the invention is to obtain a PCB which on the one hand has an antenna with a high efficiency and on the other hand is mechanically stable in the area where the antenna is arranged.

In order to achieve this object, the invention provides a PCB according to claim 1. The invention is based on the finding that it is possible to arrange a plurality of copper vias in the immediate vicinity of the antenna in a manner that the vias are not being excited by the radio energy emitted by the antenna. It is thus possible to fulfill the requirement of having a ground free area that doesn't resonate with the antenna while at the same time there is a mechanical connection which prevents the layers of the PCB from delaminating. The term "plurality" here refers to at least 15 vias and more preferably to a number of 30 to 50 vias. All copper vias are electrically insulated from one another and from a ground layer of the PCB. In other words, they are provided in a "floating manner" so as to not resonate with the antenna.

According to a preferred embodiment, the leg and the outer arm define a generally rectangular space in which the plurality of copper vias are arranged. The copper vias are arranged in this confined space in a comparatively high density.

According to an embodiment, the outer arm of the antenna terminates in a curved portion. This is advantageous regarding the transmission properties.

The copper vias are arranged in rows and columns which are oriented perpendicularly with respect to the leg and the arms. This arrangement has proven to have a minimum effect on the transmission properties of the antenna.

Preferably, some copper vias have been omitted in order to create space for a bore extending through the layers of the PCB. Omitting the vias results in obtaining an area of uninterrupted material of the PCB where the respective bore can be machined.

According to a preferred embodiment, each copper via has a rectangular cross-section, in particular a square cross-section. This geometry of the vias has also proven to have a very minimal effect on the transmission properties of the antenna.

Surprisingly, some of the copper vias can be arranged in the extension of the intermediate arm or in the space between the outer arm and the intermediate arm. Because of the vias being spaced from each other and having comparatively small dimensions, even arranging vias at these locations does not have a significant effect on the transmission properties of the antenna.

According to a preferred embodiment, a feeding point is connected to the distal end of the intermediate arm while the connection to ground is at the distal end of the leg of the antenna.

According to a preferred embodiment, two antennas are arranged in a mirror-inverted manner on the PCB. These antennas can be slightly different regarding their dimensions and geometries so as to be optimized for different frequencies.

Preferably, the outer arm of each of the antennas extends along the outer circumference of the PCB, thereby obtaining a high packaging density on the PCB.

It is also possible to arrange a plurality of vias between the legs of the two antennas.

According to an embodiment, the majority of copper vias associated with an antenna have the same dimensions and the same distance from each other. In other words, the vias are arranged according to a largely repeating, constant pattern.

According to a preferred embodiment, the distance between adjacent copper vias is between 20% and 40% of the outer length of the copper vias when viewed in a top view, in particular approximately 30%. This value has proven to be a good compromise between preventing excitations of the copper vias while at the same time achieving a high "density" which is advantageous regarding the mechanical stability achieved with the vias.

Preferably, the copper vias occupy between 15% and 50% of the entire surface of the square defined by the leg and the upper arm of the F-shaped antenna, preferably between 20% and 40%. It can be seen that the copper vias occupy a quite significant portion of the space immediately adjacent the antenna. Nevertheless, they do not (or at least not significantly) effect the transmission properties of the antenna.

The invention will now be described with reference to the enclosed drawings. In the drawings,
- Figure 1 is a schematic top view of a PCB with two antennas; and
- Figure 2 is a cross-section along line II-II of Figure 1.

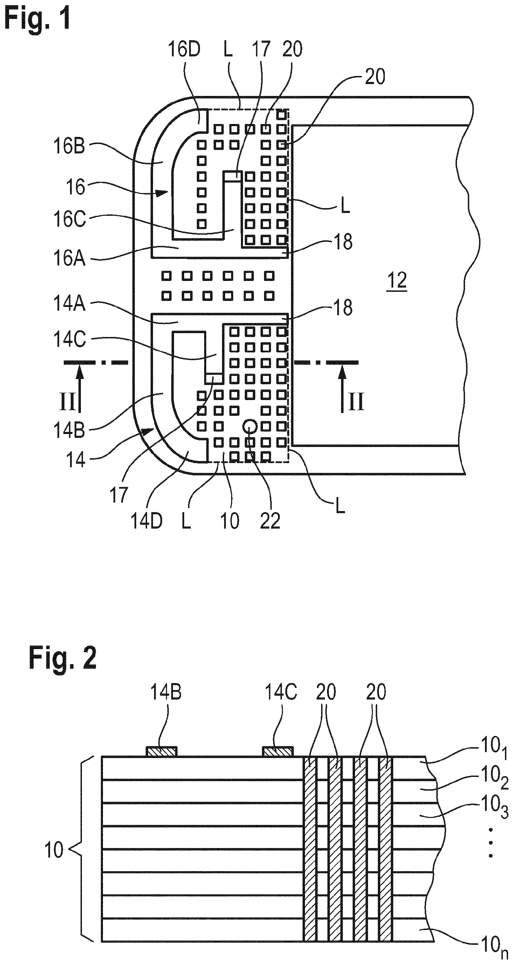

In Figures 1 and 2, a printed circuit board (PCB) 10 is schematically shown. It consists of a plurality of individual layers 10₁, 10₂, 10₃, ... 10ₙ which are laminated together.

PCB 10 has an area 12 where various electronic components and circuits are arranged, the details of which are of no importance here.

Along one of its outer edges, PCB 10 carries two antennas 14, 16. Each of them is for GSM communication. Accordingly, the antennas are cellular antennas.

Each antenna has a generally "F" shape with a leg 14A, 16A, an outer arm 14B, 16B, and an intermediate arm 14C, 16C.

Each of the outer arms 14B, 16B terminates in a curved portion 14D, 16D.

The distal end of intermediate arms 14C, 16C serves as a feeding point 17 for the respective antenna.

Further, there is a ground connection 18 at the distal end of the respective leg 14A, 16A of the respective antenna.

The antennas 14, 16 are formed as PIFA (inverted F antenna).

As can be seen in particular in Figure 2, the antennas 14, 16 are arranged on the outer surface of the uppermost layer 10.1 of PCB 10.

PCB 10 is in particular intended for a control unit of an alarm system for a building. It can comprise additional antennas, for example for Wi-Fi communication, and can carry in area 12 the control logics for the alarm system.

In order to prevent that the individual layers 10₁, 10₂, 10₃ ... 10ₙ delaminate in the area of the antenna, a plurality of copper vias 20 are provided. They extend in a direction perpendicularly to the plane in which the layers of PCB 10 extend (please see in particular Figure 2).

As can be seen in particular in Figure 1, copper vias 20 are arranged in a rectangle which is defined by leg 14A, 16A of antenna 14 or 16, and outer arm 14B, 16B. The "remaining" contour is schematically indicated with broken line L in Figure 1.

The copper vias 20 are arranged in rows and columns, which are arranged in parallel or perpendicularly to leg 14A, 16A and/or outer arm 14B, 16B.

Depending from the dimensions and the geometry of the antennas, different patterns for the copper vias can be used.

For both antennas, some copper vias are arranged in the extension of the intermediate arm 14C, 16C.

For antenna 16 which has a larger distance between arms 16B, 16C, some copper vias 20 are arranged in the space between the two arms.

As can be seen in particular in Figure 1, each via has a rectangular shape when viewed in a top view, in particular a square shape.

The copper vias 20 are arranged with a distance from each other which is smaller than the length of the respective side face of the vias. The distance can be in particular between 20% and 40% of the outer length of the vias, in particular approximately 30%.

As the vias are arranged quite close to each other, they occupy a significant portion of the entire surface of the square defined by the leg and the upper arm the respective antenna. Preferably, the vias occupy between 20% and 40% of the entire surface.

It is possible to "skip" some of the vias in order to create a space for a bore which extends through PCB 10. An example of such bore is designated with reference numeral 22 in Figure 1.

## Claims

1. A multi-layer printed circuit board, PCB, Z (10) in particular for a control unit for an alarm system, the PCB having at least one cellular antenna (14, 16) on an outermost layer, the antenna (14, 16) having the general shape of an "F" with a leg (14A, 16A), an outer arm (14B, 16B) and an intermediate arm (14C, 16C),
**characterized in that**
the PCB (10) has a plurality of massive copper vias (20) being arranged in a space defined by the leg (14A, 16A) and the outer arm (14B, 16B) of the antenna (14, 16), wherein all copper vias (20) are electrically insulated from one another and from a ground layer of the PCB (10).

2. The PCB (10) of claim 1 wherein the leg (14A, 16A) and the outer arm (14B, 16B) define a generally rectangular space in which the plurality of copper vias (20) are arranged.

3. The PCB (10) of claim 1 or claim 2 wherein the outer arm (14B, 16B) terminates in a curved portion (14D, 16D).

4. The PCB (10) of any of the preceding claims wherein the copper vias (20) are arranged in rows and columns which are oriented perpendicularly with respect to the leg (14A, 16A) and the arms (14B, 14C, 16B, 16C).

5. The PCB (10) of any of the preceding claims wherein some copper vias (20) have been omitted in order to create space for a bore (22) extending through the layers of the PCB (10).

6. The PCB (10) of any of the preceding claims wherein each copper via (20) has a rectangular cross-section.

7. The PCB (10) of claim 6 wherein the cross-section is a square.

8. The PCB (10) of any of the preceding claims wherein some of the copper vias (20) are arranged in the extension of the intermediate arm (14C, 16C).

9. The PCB (10) of any of the preceding claims wherein some of the copper vias (20) are arranged in the space between the outer arm (14B, 16B) and the intermediate arm (14C, 16C).

10. The PCB (10) of any of the preceding claims wherein a feeding point (17) is connected to the distal end of the intermediate arm (14C, 16C).

11. The PCB (10) of any of the preceding claims wherein two antennas (14, 16) are arranged in a mirror-inverted manner on the PCB (10).

12. The PCB (10) of claim 11 wherein the outer arm (14B, 16B) of each of the antennas (14, 16) extends along the outer circumference of the PCB (10).

13. The PCB (10) of claim 11 or 12 wherein a plurality of vias (20) is arranged between the legs (14A, 16A) of the two antennas (14, 16).

14. The PCB (10) of any of the preceding claims wherein the majority of copper vias (20) associated with an antenna (14, 16) have the same dimensions and the same distance from each other.

15. The PCB (10) of any of the preceding claims wherein the distance between adjacent copper vias (20) is between 20% and 40% of the outer length of the copper vias (20) when viewed in a top view, in particular approximately 30%.

16. The PCB (10) of any of the preceding claims wherein the copper vias (20) occupy between 15% and 50% of the entire surface of the square defined by the leg (14A, 16A) and the outer arm (14B, 16B) of the F-shaped antenna (14, 16), preferably between 20% and 40%.

## Patentansprüche

1. Mehrlagenleiterplatte, PCB, (10), insbesondere für eine Steuereinheit für eine Alarmanlage, wobei die Leiterplatte wenigstens eine zellulare Antenne (14, 16) auf einer äußersten Lage aufweist, wobei die Antenne (14, 16) insgesamt die Form eines "F" mit einem Schenkel (14A, 16A), einem äußeren Arm (14B, 16B) und einem Zwischenarm (14C, 16C) aufweist,
**dadurch gekennzeichnet, dass**
die Leiterplatte (10) mehrere massive Kupferdurchkontaktierungen (20) aufweist, die in einem von dem Schenkel (14A, 16A) und dem äußeren Arm (14B, 16B) der Antenne (14, 16) begrenzten Raum angeordnet sind, wobei alle Kupferdurchkontaktierungen (20) voneinander und von einer Masseschicht der Leiterplatte (10) elektrisch isoliert sind.

2. Leiterplatte (10) nach Anspruch 1, bei der der Schenkel (14A, 16A) und der äußere Arm (14B, 16B) einen insgesamt rechteckigen Raum begrenzen, in dem die mehreren Kupferdurchkontaktierungen (20) angeordnet sind.

3. Leiterplatte (10) nach Anspruch 1 oder Anspruch 2, bei der der äußere Arm (14B, 16B) in einem gekrümmten Abschnitt (14D, 16D) endet.

4. Leiterplatte (10) nach einem der vorhergehenden Ansprüche, bei der die Kupferdurchkontaktierungen (20) in Reihen und Spalten angeordnet sind, die senkrecht zum Schenkel (14A, 16A) und zu den Armen (14B, 14C, 16B, 16C) ausgerichtet sind.

5. Leiterplatte (10) nach einem der vorhergehenden Ansprüche, bei der einige Kupferdurchkontaktierungen (20) weggelassen wurden, um Platz für eine Bohrung (22) zu schaffen, die sich durch die Lagen der Leiterplatte (10) erstreckt.

6. Leiterplatte (10) nach einem der vorhergehenden Ansprüche, bei der jede Kupferdurchkontaktierung (20) einen rechteckigen Querschnitt aufweist.

7. Leiterplatte (10) nach Anspruch 6, bei der der Querschnitt ein Quadrat ist.

8. Leiterplatte (10) nach einem der vorhergehenden Ansprüche, bei der einige der Kupferdurchkontaktierungen (20) in der Verlängerung des Zwischenarms (14C, 16C) angeordnet sind.

9. Leiterplatte (10) nach einem der vorhergehenden Ansprüche, bei der einige der Kupferdurchkontaktierungen (20) in dem Raum zwischen dem äußeren Arm (14B, 16B) und dem Zwischenarm (14C, 16C) angeordnet sind.

10. Leiterplatte (10) nach einem der vorhergehenden Ansprüche, bei der ein Einspeisepunkt (17) mit dem distalen Ende des Zwischenarms (14C, 16C) verbunden ist.

11. Leiterplatte (10) nach einem der vorhergehenden Ansprüche, bei der zwei Antennen (14, 16) spiegelverkehrt auf der Leiterplatte (10) angeordnet sind.

12. Leiterplatte (10) nach Anspruch 11, bei der sich der äußere Arm (14B, 16B) jeder der Antennen (14, 16) entlang des Außenumfangs der Leiterplatte (10) erstreckt.

13. Leiterplatte (10) nach Anspruch 11 oder 12, bei der mehrere Durchkontaktierungen (20) zwischen den Schenkeln (14A, 16A) der beiden Antennen (14, 16) angeordnet sind.

14. Leiterplatte (10) nach einem der vorhergehenden Ansprüche, bei der die einer Antenne (14, 16) zugeordneten Kupferdurchkontaktierungen (20) zum Großteil die gleichen Abmessungen und den gleichen Abstand voneinander aufweisen.

15. Leiterplatte (10) nach einem der vorhergehenden Ansprüche, bei der der Abstand zwischen benachbarten Kupferdurchkontaktierungen (20) in einer Draufsicht betrachtet zwischen 20% und 40% der äußeren Länge der Kupferdurchkontaktierungen (20) beträgt, insbesondere ungefähr 30%.

16. Leiterplatte (10) nach einem der vorhergehenden Ansprüche, bei der die Kupferdurchkontaktierungen (20) zwischen 15% und 50% der gesamten Fläche des von dem Schenkel (14A, 16A) und dem äußeren Arm (14B, 16B) der F-förmigen Antenne (14, 16) begrenzten Quadrats einnehmen, vorzugsweise zwischen 20% und 40%.

## Revendications

1. Carte de circuit imprimé, PCB, multicouches (10), en particulier pour une unité de commande pour un système d'alarme, la carte de circuit imprimé présentant au moins une antenne cellulaire (14, 16) sur une couche la plus extérieure, l'antenne (14, 16) possédant la forme générale d'un « F » qui présente une branche (14A, 16A), un bras extérieur (14B, 16B) et un bras intermédiaire (14C, 16C),
**caractérisée en ce que**
la carte de circuit imprimé (10) présente plusieurs vias de cuivre massifs (20) agencés dans un espace défini par la branche (14A, 16A) et le bras extérieur (14B, 16B) de l'antenne (14, 16), tous les vias de cuivre (20) étant électriquement isolés les uns des autres et d'une couche de mise à la terre de la carte de circuit imprimé (10).

2. Carte de circuit imprimé (10) selon la revendication 1, dans laquelle la branche (14A, 16A) et le bras extérieur (14B, 16B) définissent un espace généralement rectangulaire dans lequel les plusieurs vias de cuivre (20) sont agencés.

3. Carte de circuit imprimé (10) selon la revendication 1 ou la revendication 2, dans laquelle le bras extérieur (14B, 16B) se termine dans un tronçon courbe (14D, 16D).

4. Carte de circuit imprimé (10) selon l'une des revendications précédentes, dans laquelle les vias de cuivre (20) sont agencés en rangées et en colonnes qui sont orientées perpendiculairement par rapport à la branche (14A, 16A) et aux bras (14B, 14C, 16B, 16C).

5. Carte de circuit imprimé (10) selon l'une des revendications précédentes, dans laquelle certains vias de cuivre (20) ont été omis pour créer un espace pour un orifice (22) qui s'étend à travers les couches de la carte de circuit imprimé (10).

6. Carte de circuit imprimé (10) selon l'une des revendications précédentes, dans laquelle chaque via de cuivre (20) présente une section transversale rectangulaire.

7. Carte de circuit imprimé (10) selon la revendication 6, dans laquelle la section transversale est carrée.

8. Carte de circuit imprimé (10) selon l'une des revendications précédentes, dans laquelle certains des vias de cuivre (20) sont agencés dans le prolongement du bras intermédiaire (14C, 16C).

9. Carte de circuit imprimé (10) selon l'une des revendications précédentes, dans laquelle certains des vias de cuivre (20) sont agencés dans l'espace entre le bras extérieur (14B, 16B) et le bras intermédiaire (14C, 16C).

10. Carte de circuit imprimé (10) selon l'une des revendications précédentes, dans laquelle un point d'alimentation (17) est connecté à l'extrémité distale du bras intermédiaire (14C, 16C).

11. Carte de circuit imprimé (10) selon l'une des revendications précédentes, dans laquelle deux antennes (14, 16) sont agencées à symétrie spéculaire sur la carte de circuit imprimé (10).

12. Carte de circuit imprimé (10) selon la revendication 11, dans laquelle le bras extérieur (14B, 16B) de chacune des antennes (14, 16) s'étend le long de la circonférence extérieure de la carte de circuit imprimé (10).

13. Carte de circuit imprimé (10) selon la revendication 11 ou 12, dans laquelle plusieurs vias (20) sont agencés entre les branches (14A, 16A) des deux antennes (14, 16).

14. Carte de circuit imprimé (10) selon l'une des revendications précédentes, dans laquelle la majorité des vias de cuivre (20) associés à une antenne (14, 16) ont les mêmes dimensions et la même distance les uns des autres.

15. Carte de circuit imprimé (10) selon l'une des revendications précédentes, dans laquelle la distance entre des vias de cuivre (20) adjacents est de 20% à 40%, en particulier environ de 30% de la longueur extérieure des vias de cuivre (20), vus dans une vue de dessus.

16. Carte de circuit imprimé (10) selon l'une des revendications précédentes, dans laquelle les vias de cuivre (20) occupent entre 15% et 50%, de préférence entre 20% et 40% de la surface totale du carré défini par la branche (14A, 16A) et le bras extérieur (14B, 16B) de l'antenne en forme de F (14, 16).
